Europäisches Patentamt

**European Patent Office**

Office européen des brevets

(19)

(11) Veröffentlichungsnummer : **0 031 492**

**B1**

(12)

# EUROPÄISCHE PATENTSCHRIFT

(45) Veröffentlichungstag der Patentschrift :
09.03.83

(21) Anmeldenummer : **80107620.9**

(22) Anmeldetag : **04.12.80**

(51) Int. Cl.³ : **G 11 C 11/40, G 11 C 7/00**

(54) **Halbleiterspeichermatrix mit statischen Speicherzellen.**

(30) Priorität : **28.12.79 US 107812**

(43) Veröffentlichungstag der Anmeldung :
**08.07.81 Patentblatt 81/27**

(45) Bekanntmachung des Hinweises auf die Patenterteilung : **09.03.83 Patentblatt 83/10**

(84) Benannte Vertragsstaaten :
**DE FR GB**

(56) Entgegenhaltungen :
**DE A 2 041 507**
**US A 3 573 758**
**US A 3 618 052**
**US A 3 688 279**
**US A 3 745 540**
**US A 3 764 825**
**US A 3 886 531**
**US A 4 032 902**
**US A 4 035 784**
**US A 4 090 255**
**US A 4 158 237**

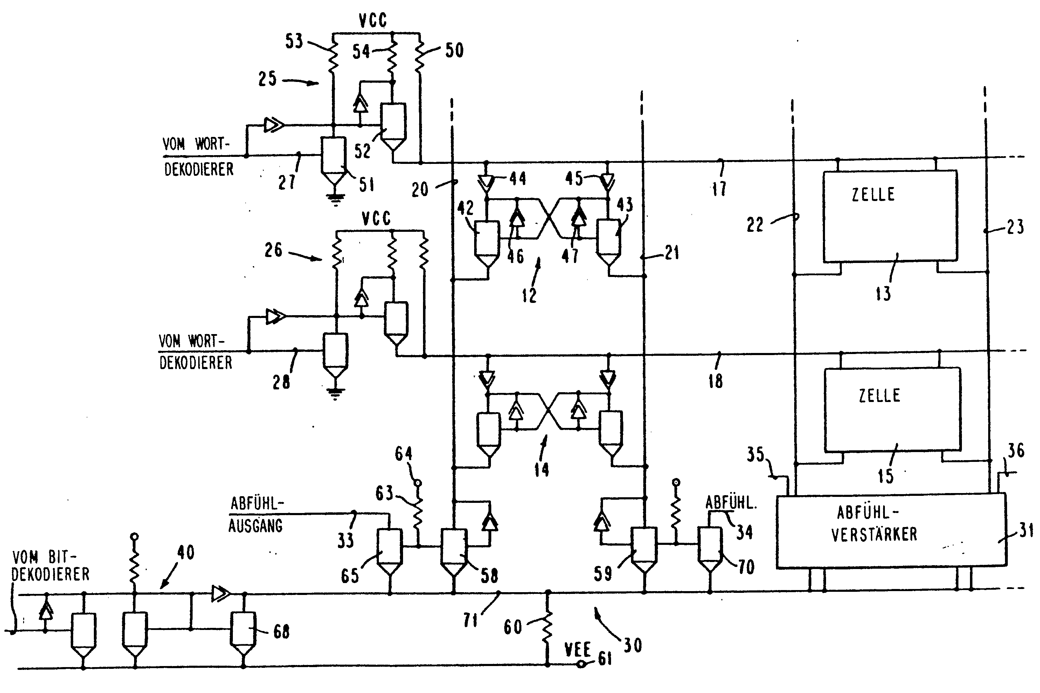

**IEEE JOURNAL OF SOLID STATE CIRCUITS Band
SC2, Nr. 4, Dezember 1967, New York US IWER-
SEN et al. « Beam-lead sealed-junction semiconductor memory with minimal cell complexity »,
Zeilen 196-201. Abschnitt « Memory Cell » und
« World-Select and Digit Circuits » Figuren 1, 6-7.**

(73) Patentinhaber : **International Business Machines Corporation**

**Armonk, N.Y. 10504 (US)**

(72) Erfinder : **Malaviya, Shashi Dhar**
**1 Trenton Road**
**Fishkill New York 12524 (US)**

(74) Vertreter : **Lewit, Leonard, Dipl.-Ing.**
**Schönaicher Strasse 220**
**D-7030 Böblingen (DE)**

Halbleiterspeichermatrix mit statischen Speicherzellen

Die Erfindung betrifft einen Halbleiterspeicher der im Oberbegriff des Anspruchs 1 angegebenen Art. Ein derartiger Speicher ist beispielsweise aus der DE-A-2 041 507 bekannt. Meist wird ein solcher Speicher als Schreib/Lesespeicher verwendet, während Speicher, die nur gelesen werden (Festwertspeicher) häufig nur eine Diode im Kreuzungspunkt zwischen einer Wortleitung und einer Bitleitung vorsehen. Dabei kann der Anschluß dieser Diode bei der Herstellung des Speichers je nach zu speicherndem Bitmuster unterbrochen werden. Je nach gespeichertem Bit fließt also bei der Auswahl der betreffenden Wortleitung ein Strom zur Bitleitung oder nicht.

Bei einem Aufbau eines Halbleiterspeichers mit einer statischen Zelle, die aus zwei kreuzgekoppelten Transistoren besteht, können zwei Bitleitungen vorgesehen werden, wobei ein Lesesignal auf der einen oder anderen Bitleitung in Abhängigkeit davon erhalten wird, welcher der beiden Transistoren leitend ist.

Der Erfindung liegt die Aufgabe zugrunde, in einem Halbleiterspeicher der eingangs beschriebenen Art die Störsicherheit und die Verwendungsmöglichkeiten zu erhöhen. Die Lösung dieser Aufgabe ist in den anliegenden Ansprüchen gekennzeichnet.

Durch die niederohmige Verbindung zwischen den Emittoren der beiden Speichertransistoren kann die Arbeitsgeschwindigkeit der Speicherzelle beim Einschreiben erhöht werden. Die niederohmige Verbindung vermindert auch die Anfälligkeit gegen Störsignale und ermöglicht dadurch eine Erhöhung der Speicherzellendichte. Dies wird auch dadurch erreicht, daß die Emittorspannung klein gehalten werden kann und dadurch eine maximale Kollektorspannungsdifferenz für jede Zelle erzielt wird. Außerdem wird die Spannung an den beiden Emittoren auf gleicher Höhe gehalten, so daß das unbeabsichtigte Umschalten der Speicherzelle durch Störsignale auf den Bit- oder Wortleitungen vermieden wird.

Nach einer vorteilhaften Weiterbildung kann die niederohmige Anschlußschaltung für die Bitleitungen auch für eine Speicherzelle verwendet werden, die dadurch modifiziert wurde, daß die Kreuzkopplung der beiden Transistoren unterbrochen wurde. Auf diese Weise wird ein Festwertspeicher erzielt, wobei die genannte Modifikation leicht während des Herstellprozesses durchgeführt werden kann. Die beiden Speichertransistoren werden hierdurch zu Dioden, die jeweils mit einer eigenen Bitleitung verbunden sind.

Ein Ausführungsbeispiel der Erfindung soll nun anhand der einzigen Figur beschrieben werden. In der Figur sind vier repräsentative Speicherzellen 12 bis 15 gezeigt, welche matrixartig an Wortleitungen 17 und 18 sowie an gepaarte Bitleitungen 20, 21 und 22, 23 angeschlossen sind. Jede Wortleitung 17, 18 ist an einen Worttreiber 25, 26 angeschlossen, der die Wortleitung mit einer Spannung versorgt, die geeignet zum Lesen, Schreiben und Speicheroperationen ist. Ein Worttreiber wird mittels eines Signales auf einer Leitung 27 oder 28 von einem nicht gezeigten Adreßdekodierer ausgewählt. Die beiden Bitleitungen einer Bitposition sind mit einem Abfühlverstärker 30, 31 verbunden und während einer Leseoperation erzeugt jeder Abfühlverstärker ein Signal auf einer von zwei betreffenden Ausgangsleitungen 33 oder 34 sowie 35 oder 36 und gibt damit an, daß in der Speicherzelle für die betreffende Bitposition des ausgewählten Wortes eine binäre 1 oder eine binäre 0 gespeichert war.

Für die gezeigte Speichermatrix kann auch eine Bitauswahlschaltung 40 vorgesehen werden, die einen oder mehrere ausgewählte Abfühlverstärker der Matrix während einer Leseoperation einschaltet. Für die Speichermatrix sind auch nicht gezeigte Bitleitungstreiber vorgesehen, die ein Signal auf der einen oder der anderen der beiden Bitleitungen einer Bitposition für eine Schreiboperation erzeugen.

Die verwendete Speicherzelle 12 hat zwei bipolare Transistoren 42 und 43, welche über Schottky Dioden oder andere Lastelemente 44, 45 mit einer Wortleitung verbunden sind und Strom von dieser Wortleitung 17 beziehen. Basis und Kollektor der Transistoren 42, 43 sind untereinander in bekannter Weise kreuzgekoppelt, um eine bistabile Funktionsweise zu ermöglichen. Die Speicherzelle kann auch Schottky-Dioden 46 und 47 enthalten, die derart zwischen Basis und Kollektor der Transistoren verbunden sind, daß eine Sättigung der Transistoren vermieden wird.

Um Daten in die Zelle einzuspeichern, wird einer der Transistoren 42 oder 43 eingeschaltet und der andere Transistor ausgeschaltet. Der leitende Transistor bezieht Strom aus der mit ihm verbundenen Bitleitung. Für eine Leseoperation wird die Spannung auf der Wortleitung erhöht, wodurch die Zelle von einem Zustand niedriger Leitfähigkeit in einen Zustand hoher Leitfähigkeit überführt wird. Der damit verbundene Anstieg des Emittorstromes in einem der beiden Transistoren wird als Anstieg des Stromes in der betreffenden, mit dem leitenden Transistor verbundenen Bitleitung, festgestellt. Für eine Einschreiboperation wird die Spannung auf einer ausgewählten der beiden Bitleitungen erhöht und/ oder die Spannung auf der anderen Leitung erniedrigt, wodurch der gewünschte Transistor der Zelle leitend gemacht wird.

In der Worttreiberschaltung 25 ist ein Widerstand 50 mit einer Bezugsspannung VCC verbunden, wodurch eine Stromquelle realisiert wird, welche die Wortleitung 17 speist. Diese Stromquelle liefert den Strom für den Zustand niedriger Leitfähigkeit der Zelle. Zur Lieferung des hohen Stromes, der von einer Zelle im Zustand hoher Leitfähigkeit verbraucht wird, sind die Kollektorwiderstände 53 und 54 von zwei Transistoren 51 und 52 sowie eine Schottky-Diode 55 zur Vermeidung einer Sättigung vorgesehen. Während des Speicherbetriebes ist der Transistor 52 nichtleitend und wird der Transistor 51 durch ein hohes Potential auf der Leitung 27 leitend gehalten. Wenn das Signal auf der Leitung 27 fällt, wird der Transistor 51 ausgeschaltet und der Transistor 52 eingeschaltet. Der Transistor 52 liefert nun zusätzlichen Strom über den Widerstand 54 zur Wortleitung. Ein weiterer nicht gezeigter Treiber ist für eine Schreiboperation vorgesehen.

In der Abfühlschaltung ist die Bitleitung 20 mit dem Kollektor eines Transistors 58 und die Bitleitung 21 mit dem Kollektor eines Transistors 59 verbunden. Die Emittoren der beiden Transistoren 58 und 59 sind mit einer Stromquelle verbunden, die aus einem Widerstand 60 und einer Speisespannung VEE am Punkt 61 gebildet wird. Die genannte Stromquelle kann in bekannter Weise auch aus anderen Elementen gebildet werden. Es kann beispielsweise ein Emitterwiderstand vorgesehen werden und eine Referenzspannung an die Basisemittorstrecke eines Transistors angelegt werden. Ein weiterer Widerstand 63 verbindet die Basis des Transistors 58 mit einem Speisepunkt 64 und bestimmt somit den Basisstrom für den Transistor 58 und einen weiteren Transistor 65, dessen Basis ebenfalls mit dem Widerstand 63 verbunden ist. Da die Basisanschlüsse und die Emittoranschlüsse der Transistoren miteinander verbunden sind, sind auch ihre Kollektorströme im wesentlichen gleich, und ein Wechsel im Bitleitungsstrom am Kollektor des Transistors 58 erzeugt einen entsprechenden Wechsel im Kollektorstrom des Transistors 65 und damit in einer Ausgangsleitung 33, die mit dem Kollektor des Transistors 65 verbunden ist.

Es soll nun eine Leseoperation beschrieben und angenommen werden, daß die Wortleitung 17 ausgewählt wurde und daß der Transistor 42 leitend und der Transistor 43 nichtleitend ist. Ein Anstieg der Spannung auf der Wortleitung 17 erlaubt einen wesentlichen Anstieg des Stromflusses in der Kollektor-Emittorstrecke des Transistors 42 und damit in der Bitleitung 20. Der Strom in der Bitleitung 21 wird jedoch nicht wesentlich erhöht, da der Transistor 43 im gezeigten Beispiel nichtleitend ist. Der Wert des Widerstandes 63 und des Potentials am Punkt 64 wird derart gewählt, daß dem Transistor 58 ein Basisstrom zugeführt wird, der diesem erhöhten Strom in der Bitleitung während einer Leseoperation entspricht. Die Veränderung der Kollektorspannung am Transistor 58 wird hierdurch niedrig gehalten. Zur Leseoperation wird der Transistor 68 in der Bitauswahlschaltung 40 eingeschaltet und bildet eine Stromquelle für die Transistoren 58 und 65, oder 59 und 70.

Es soll nun eine Schaltung betrachtet werden, die nur aus der Speicherzelle 12, dem Knoten 71 und passiven Widerständen anstelle der Transistoren 58 und 59 besteht. Eine solche Vereinfachung der in der Figur dargestellten Schaltung entspricht einem emittorgekoppelten Flipflop. In einer solchen Schaltung erfolgt die Umschaltung der beiden gekoppelten Transistoren nicht nur durch die Verbindung zwischen Basis und Kollektor der beiden Transistoren 42 und 43, sondern auch über die Emittorkopplung. Wenn der leitende Transistor, beispielsweise der Transistor 42 beginnt nichtleitend zu werden, verändert sich das gemeinsame Emittorpotential der beiden Transistoren und wird der nichtleitende Transistor 43 leitend gemacht. Durch den Abfall des Emittorpotentials des Transistors 42, der nichtleitend wird, erhöht sich die Basisemittorspannung des leitend werdenden Transistors 43, und es wird auf diese Weise der Umschaltvorgang verstärkt. Widerstände, die den beiden Transistoren 58 und 59 entsprechen, werden oft dazu verwendet, die Emittorspannung des damit verbundenen Transistors abzutrennen, d. h. gegenzukoppeln, wodurch eine Kompensation von Variationen in der Basisemittorcharakteristik erzielt wird. Ein hoher Wert für solche Abtrennungswiderstände würde jedoch die beiden Emittoranschlüsse isolieren und dadurch den Kopplungseffekt und die Umschaltgeschwindigkeit der kreuzgekoppelten Transistoren vermindern. Solche Widerstände erzeugen eine Gegenkopplung. Im Gegensatz hierzu gestattet die erfindungsgemäße Schaltung die Abtrennung der beiden Emittoranschlüsse der Speicherzellentransistoren an der Bitleitung, ermöglicht jedoch weiterhin eine Kopplung der beiden Zellentransistoren, wobei für die beiden Transistoren 58 und 59 nur eine minimale Potentialdifferenz vorgesehen werden muß.

Ein Vorteil der Isolation der Emittoranschlüsse innerhalb der Speicherzelle besteht darin, daß die Speichermatrix als Festwertspeicher benutzt werden kann, indem eine der beiden Emittorverbindungen der Zelle zu der betreffenden Bitleitung unterbrochen wird. Die Speichermatrix kann in vorteilhafter Weise als Lese/Schreibmatrix während der Entwicklungsphase eines geeigneten Datenmusters verwendet werden, und es kann darauffolgend unter Beibehaltung des Chipentwurfes ein Festwertspeicher gebildet werden.

Die Zelle 12 kann auch zu zwei Festwertspeicherzellen dadurch umgeformt werden, daß die Verbindungen zu den Kollektoranschlüssen der Transistoren 42 und 43 entweder nicht vorgesehen oder aber unterbrochen werden. Eine solche Festwertspeicherzelle wird z. B. aus der Serienverbindung der Schottky-Diode 45 und einer weiteren Diode erzeugt, die durch die Basisemittordiode des Transistors 42 gebildet wird. Die andere Zelle wird aus der Schottky-Diode 44 und der Basisemittordiode des Transistors 43 gebildet. Dieser Pfad zwischen der Wortleitung 17 und einer Bitleitung 20 oder 21 stellt den einen binären Speicherzustand dar und eine Schaltung, die dadurch unterbrochen ist, daß beispielsweise bei der Herstellung die Metallanode einer der Schottky-Dioden 44 oder 45 nicht erzeugt wird, stellt den anderen binären Wert dar. In einem solchen Festwertspeicher bilden die Transistoren 58 und 65 sowie die damit verbundenen Schaltungskomponenten eine Abfühlschaltung für die Bitleitung 20 und die Transistoren 59 und 70 sowie die damit verbundenen Schaltungskomponenten eine weitere, unabhängige Abfühlschaltung für die Bitleitung 21.

**Ansprüche**

1. Halbleiterspeichermatrix mit statischen Speicherzellen aus zwei kreuzgekoppelten Transistoren zwischen einer Wortleitung, einem Paar Bitleitungen, wobei die Einzelemittoren der Zellentransistoren mit je einer Bitleitung verbunden sind, dadurch gekennzeichnet, daß die beiden Bitleitungen (20, 21) jeweils mit den Kollektoren von zwei Abfühltransistoren (58, 59) geringer Impedanz verbunden sind, deren Emittoren untereinander und mit einer gemeinsamen Stromquelle (61, 60) verbunden sind.

2. Speichermatrix nach Anspruch 1, dadurch gekennzeichnet, daß die gemeinsame Stromquelle aus einem Widerstand (60) und einer Spannungsquelle (VEE, 61) besteht.

3. Speichermatrix nach Anspruch 1, dadurch gekennzeichnet, daß die Basiselektroden der beiden Abfühltransistoren (58, 59) zur Einspeisung eines konstanten Basisstromes über je einen Widerstand (z. B. 63) mit einer Spannungsquelle (z. B. 64) verbunden sind.

4. Speichermatrix nach Anspruch 3, dadurch gekennzeichnet, daß mit jedem Abfühltransistor (z. B. 58) ein weiterer Transistor (65) derart verbunden ist, daß Basiselektroden und Emittorelektroden der beiden Transistoren (65, 58) direkt miteinander verbunden sind und daß am Kollektor des weiteren Transistors (65) das Lesesignal (Leitung 33) abgenommen wird.

5. Speichermatrix nach Anspruch 1, dadurch gekennzeichnet, daß die Kollektoren der beiden Zellentransistoren (42, 43) jeweils über eine erste Schottky-Diode (44, 45) mit der Wortleitung (17) und direkt mit der Basiselektrode des anderen Zellentransistors verbunden sind und daß jeweils zwischen Basis und Kollektor eines Zellentransistors eine zweite Schottky-Diode (46, 47) vorgesehen ist.

6. Speichermatrix nach Anspruch 5, dadurch gekennzeichnet, daß zur Herstellung einer Festwertspeicherzelle die Verbindung zwischen Emittor eines der beiden Zellentransistoren (z. B. 42) und der angeschlossenen Bitleitung (20) unterbrochen wird.

7. Speichermatrix nach Anspruch 5, dadurch gekennzeichnet, daß zur Herstellung einer Festwertspeicherzelle die Verbindung zu den Kollektoranschlüssen der Zellentransistoren (42, 43) unterbrochen wird und daß zur Einspeicherung des gewünschten Bitmusters die Verbindung zur Anode einer der ersten Schottky Dioden (44, 45) unterbrochen wird.

8. Speichermatrix nach Anspruch 5, dadurch gekennzeichnet, daß zur Aufrechterhaltung des Speicherzustandes die Wortleitung (17) über einen Widerstand (50) mit einer Speisespannung (VCC) verbunden ist und daß zur Einspeisung eines höheren Stromes während des Lesevorganges die Wortleitung (17) über einen Transistor (52) und einen Widerstand (54) mit der Speisespannung (VCC) verbindbar ist.

**Claims**

1. Semiconductor storage matrix comprising static storage cells consisting of two crosscoupled transistors between a word line, a pair of bit lines, the individual emitters of the cell transistors being connected to one respective bit line, characterized in that the two bit lines (20, 21) are respectively connected to the collectors of two sensing transistors (58, 59) of a lower impedance whose emitters are connected to each other and to a common current source (61, 60).

2. Storage matrix as claimed in claim 1, characterized in that the common current source consists of a resistor (60) and a voltage source (VEE, 61).

3. Storage matrix as claimed in claim 1, characterized in that the base electrodes of the two sensing consistors (58, 59) are connected for feeding a constant base current via one respective resistor e. g. (63) to a voltage source e. g. (64).

4. Storage matrix as claimed in claim 3, characterized in that each sensing transistor (e. g. 58) is connected to an additional transistor (65) in such a manner that base electrodes and emitter electrodes of the two transistors (65, 68) are directly interconnected, and that the read signal (line 33) is picked up at the collector of the additional transistor (65).

5. Storage matrix as claimed in claim 1, characterized in that the collectors of the two cell transistors (42, 43) are respectively connected via a first Schottky diode (44, 45) to the word line (17), and directly to the base electrode of the other cell transistor, and that between base and collector of each cell transistor a second Schottky diode (46, 47) is provided.

6. Storage matrix as claimed in claim 5, characterized in that for making a read only storage cell the connection between emitter of one of the two cell transistors (e. g. 42) and the connected bit line (20) is interrupted.

7. Storage matrix as claimed in claim 5, characterized in that for making a read only storage cell the connection to the collector connectors of the cell transistor (42, 43) is interrupted, and that for storing the respective bit pattern the connection to the anode of one of the first Schottky diodes (44, 45) is interrupted.

8. Storage matrix as claimed in claim 5, characterized in that for maintaining the storage state the word line (17) is connected via a resistor (50) to a feeding voltage (VCC), and in that for feeding a higher current during reading the word line (17) can be connected via a transistor (52) and a resistor (54) to the feeding voltage (VCC).

## Revendications

1. Matrice de mémoire à semi-conducteurs formée de cellules de mémoire statiques composées de deux transistors couplés en croix et disposés entre une ligne de mots, et une paire de lignes de bits, les émetteurs individuels des transistors de chaque cellule étant reliés, respectivement, à une ligne de bits, caractérisée par le fait que les deux lignes de bits (20, 21) sont reliées chacune aux collecteurs de deux transistors de lecture (58, 59) de faible impédance dont les émetteurs sont reliés entre eux et à une source de courant commune (61, 60).

2. Matrice de mémoire selon la revendication 1, caractérisée par le fait que la source de courant commune est composée d'une résistance (60) et d'une source de tension (VEE, 61).

3. Matrice de mémoire selon la revendication 1, caractérisée par le fait que les électrodes de base des deux transistors de lecture (58, 59) sont reliées à une source de tension (par exemple 64), pour l'injection d'un courant de base constant, passant à chaque fois, par une résistance (par exemple 63).

4. Matrice de mémoire selon la revendication 3, caractérisée par le fait qu'à chaque transistor de lecture (par exemple 58) est relié un autre transistor (65) de telle sorte que les électrodes de base et les électrodes d'émetteur des deux transistors (65, 68) sont directement reliées entre elles, et que le signal de lecture (ligne 33) est prélevé au niveau du collecteur de l'autre transistor (65).

5. Matrice de mémoire selon la revendication 1, caractérisée par le fait que les collecteurs des deux transistors de cellule (42, 43) sont respectivement reliés, par l'intermédiaire d'une première diode Schottky (44, 45), à la ligne de mots (17) et, directement, à l'électrode de basé de l'autre transistor de cellule et qu'entre la base et le collecteur d'un transistor de cellule est toujours prévue une seconde diode Schottky (46, 47).

6. Matrice de mémoire selon la revendication 5, caractérisée par le fait que, pour la réalisation d'une cellule de mémoire morte, la liaison entre l'émetteur d'un des deux transistors de cellule (par exemple 42) et la ligne de bits raccordée (20) est coupée.

7. Matrice de mémoire selon la revendication 5, caractérisée par le fait que pour la réalisation d'une cellule de mémoire morte, la liaison aux contacts du collecteur des transistors de cellule (42, 43) est coupée et que, pour la mise en mémoire du bit désiré, la liaison avec l'anode d'une des premières diodes Schottky (44, 45) est coupée.

8. Matrice de mémoire selon la revendication 5, caractérisée par le fait que, pour maintenir l'état de mémorisation, la ligne de mots (17) est reliée, par l'intermédiaire d'une résistance (50), à une tension d'alimentation (VCC) et que, pour l'alimentation avec une intensité plus élevée pendant le processus de lecture, la ligne de mots (17) peut être reliée, par l'intermédiaire d'un transistor (52) et d'une résistance (54), à la tension d'alimentation (VCC).